(19) Europäisches Patentamt

European Patent Office

Office européen des brevets

(11) **EP 1 324 062 B1**

(12) **EUROPÄISCHE PATENTSCHRIFT**

(45) Veröffentlichungstag und Bekanntmachung des Hinweises auf die Patenterteilung:
**17.05.2006 Patentblatt 2006/20**

(51) Int Cl.:
***G01R 31/36*** *(2006.01)*

(21) Anmeldenummer: **02023888.7**

(22) Anmeldetag: **24.10.2002**

(54) **Verfahren zur Ermittlung des Betriebszustands einer Speicherbatterie**

Method for determining the operating state of a storage battery

Procédé de détermination de l'état de fonctionnement d'une batterie d'accumulateurs

(84) Benannte Vertragsstaaten:
**AT BE BG CH CY CZ DE DK EE ES FI FR GB GR IE IT LI LU MC NL PT SE SK TR**

(30) Priorität: **14.12.2001 DE 10161640**

(43) Veröffentlichungstag der Anmeldung:
**02.07.2003 Patentblatt 2003/27**

(73) Patentinhaber: **VB Autobatterie GmbH & Co. KGaA.**
**30419 Hannover (DE)**

(72) Erfinder: **Koch, Ingo**
**31789 Hameln (DE)**

(74) Vertreter: **Gerstein, Hans Joachim et al**
**Gramm, Lins & Partner GbR**
**Theodor-Heuss-Strasse 1**
**38122 Braunschweig (DE)**

(56) Entgegenhaltungen:
**EP-A- 0 154 033     EP-B- 0 438 477**
**DE-A- 19 847 648     DE-A- 19 952 693**
**US-A- 5 565 759**

• **A.M. KREIPP ET.AL.: "Batterie- und Energiemanagement" ELEKTRONIK IM KRAFTFAHRZEUG 2001, VDI-GESELLSCHAFT, 27. - 28. September 2001, Seiten 495-511, XP001174160**

**EP 1 324 062 B1**

**Beschreibung**

Die Erfindung betrifft ein Verfahren zur Ermittlung des Betriebszustands einer Speicherbatterie für einen aktuellen Alterungszustand bei angenommenen Temperatur- und Ladezustandsbedingungen mit den Schritten:

a) Messen einer Temperaturgröße, die mit der Batterietemperatur korreliert;

b) Ermitteln des Ladezustands der Speicherbatterie;

c) Ermitteln einer weiteren Zustandsgröße ($A_{IST}$) der Speicherbatterie.

In der DE 37 12 629 C2 ist eine Messvorrichtung für die verbleibende Lebensdauer einer Kraftfahrzeugbatterie beschrieben, die die Batteriespannung und den dazugehörigen Laststromwert vor und nach dem erstmaligen Starten bei vollgeladenem Zustand der Batterie erfasst, den temperaturkompensierten Innenwiderstand ermittelt und in einem Speicher ablegt sowie mit den bei den späteren Startvorgängen der Verbrennungskraftmaschine ermittelten Innenwiderstandswerten vergleicht. Die Anzeige der verbleibenden Lebensdauer erfolgt danach in Abhängigkeit von vorgegebenen, abgespeicherten Schwellwerten.

Aus der EP 0 438 477 B1 (DE 689 24 169 T2) ist ein Fahrzeug-Batterie-Betriebszustandsmonitor bekannt. Eine Fahrzeugbatterie wird überwacht, um die Batteriekapazität, den Ladezustand und bestimmte Fehlzustände zu ermitteln. Die Umgebungstemperatur, Batteriespannung, Lichtmaschinen-/Regler-Ausgangsspannung und Ströme in und aus der Batterie werden kontinuierlich gemessen. Strom-Spannungs-Daten werden analysiert, um den Innenwiderstand und die Polarisation der Batterie zu ermitteln. Zudem wird eine Untersuchung bezüglich des Ladezustands und von Fehlzuständen, die von korrodierten Anschlussklemmen und niedrigem Elektrolytstand herrühren, gemacht. Die Kaltstartgrenze wird durch den Vergleich der möglichen Leistungsabgabe der Fahrzeugbatterie mit der Leistungsanforderung des Fahrzeugs für den Startvorgang ermittelt. Durch den Vergleich erzeugte Daten werden am Armaturenbrett des Fahrzeugs angezeigt.

In der EP 0 548 266 B1 (DE 0 548 266 T2) ist ein elektronischer Tester zum Bewerten der Kapazität einer Batterie oder einer Zelle offenbart. Eine unabhängige elektronische Schaltung bewertet augenblicklich das Energiespeichervermögen einzelner Zwei-Volt-Bleisäurezellen oder von Batterien, die aus solchen Zellen bestehen. Das Testgerät ist elektrisch mit den Anschlüssen einer Zelle oder Batterie verbunden und misst die dynamische Leitfähigkeit mit einem kleinen zeitveränderlichen Signal. Eine interne Standardleitfähigkeit erlaubt das Kalibrieren des Gerätes, um die Genauigkeit der Zellen-/Batterie-Messungen sicherzustellen. Hilfsklemmen bieten die Möglichkeit zum Anschluss einer "Referenzleitfähigkeit", die als die dynamische Leitfähigkeit einer identisch ausgelegten und produzierten Zelle oder Batterie mit 100 %iger Energiespeicherung definiert ist. Das Gerät zeigt entweder die Leitfähigkeit der getesteten Zelle/ Batterie in Siemens (mhos) oder ihre durch Normierung der gemessenen Leitfähigkeit in Bezug auf die "Referenzleitfähigkeit" ermittelte "prozentuale Kapazität" an. Bei Ermittlung der "prozentualen Kapazität" leuchtet eine Leuchtdiode auf, wenn das Ergebnis kleiner als ein voreingestellter Grenzwert ist. Bei Einzelzelleneinsatz verhindern spezielle Vorrichtungen das direkte Speisen der Hochstromelemente des Messkreises durch die im Test befindliche Zwei-Volt-Zelle durch Versorgen dieser Elemente mit niedrigem Strom aber höherer Spannung aus einer gesonderten Niedrigenergie-Gleichstromquelle, beispielsweise einer kleinen 9-Volt-Transistorbatterie oder einem fest eingebauten Gleichspannungswandler, der durch die im Test befindliche Zelle gespeist wird. Diese Schaltungsausführung ermöglicht ein transportables, unabhängiges elektronisches Instrument, dass eine exakte augenblickliche Beurteilung "prozentualen Kapazität" einer Zwei-Volt-Zelle oder einer Batterie, die aus solchen Zellen besteht, ohne eine zusätzliche externe Energieversorgung ermöglicht.

Die DE 197 50 309 A1 betrifft ein Verfahren zur Bestimmung der Startfähigkeit einer Starterbatterie eines Kraftfahrzeuges, bei dem der Mittelwert des Spannungseinbruchs beim Starten des Verbrennungsmotors gemessen und mit den Spannungswerten eines Kennlinienfeldes verglichen wird, wobei das Kennlinienfeld gemessene Spannungseinbrüche und zugehörige Batterie- sowie Motortemperaturen wiedergibt. In dem Verfahren wird die Abweichung des momentan ermittelten Spannungseinbruchs von dem im Kennlinienfeld abgelegten Spannungseinbruch ermittelt und es wird eine Anzeige- und Alarmfunktion ausgelöst, sobald die Abweichung einen vorgegebenen Schwellwert überschreitet.

Mit den herkömmlichen Verfahren kann zwar bereits der aktuelle Zustand einer Speicherbatterie zuverlässig ausgewertet und der Innenwiderstand für die aktuelle Batterietemperatur und den aktuellen Ladezustand bestimmt werden. Eine Vorhersage des Betriebszustandes unter dem Einfluss des Betriebsalters der Speicherbatterie für beliebige weitere angenommene Temperatur- und Ladezustandsbedingungen ist hingegen nicht möglich.

In der EP 0 154 033 A1 ist ein Prüfverfahren für Speicherbatterien offenbart, bei dem aus Spannungsmessungen der aktuelle Ladezustand und der aktuelle Gleichstrominnenwiderstand ermittelt wird. Der Gleichstrominnenwiderstand wird im Bezug zu typengleichen Neuwerten gesetzt, um eine Maßzahl für das momentane Startvermögen der Starterbatterie zu erhalten.

Aus A. M. Kreipp et al.: "Batterie- und Energiemanagement", in: Elektronik im Kraftfahrzeug 2001, VDI-Gesellschaft, 27.-28. September 2001, Seiten 495 bis 511 ist ein Verfahren zur Batteriediagnose und dynamischen Energiemanagements für Kraftfahrzeuge bekannt, bei dem die Batteriespannung, die Batterietemperatur und der Batteriestrom ermittelt und hieraus aktuell der Ladezustand, die Leistungsfähigkeit und die Speicherkapazität der Batterie bestimmt werden. Hierbei erfolgt eine Bewertung mit Hilfe von in einem Speicher hinterlegten Batteriekennlinien. Weiterhin wird der Innenwiderstand bei einer gegebenen Temperatur bestimmt. Die aktuelle Batteriekapazität wird aus den zwischen den zwei Messpunkten der Ruhespannungsermitteln umgesetzten Amperestunden ermittelt, die in Beziehung zu einem empirischen Faktor gesetzt werden. Eine Prognose der Leistungsfähigkeit der Batterie erfolgt durch Auslesen von für einen Motorstart notwendigen Größenstartstrom und Startspannung in Abhängigkeit von der zu erwartenden Temperatur, wobei die Größen in einem Aggregat-Kennfeld hinterlegt sind. Diese ausgelesenen Kenngrößen werden dann mit der zuvor ermittelten aktuellen Leistungsfähigkeit der Batterie verglichen.

Aufgabe der vorliegenden Erfindung war es, ein Verfahren zur Ermittlung des Betriebszustands einer Speicherbatterie zu schaffen, bei dem der Betriebszustand unter angenommenen Temperatur- und Ladezustandsbedingungen durch einfaches Messen einer mit der Batterietemperatur korrelierenden Temperaturgröße, Ermitteln des Ladezustands und einer weiteren Zustandsgröße der Speicherbatterie für beliebige weitere angenommene Temperatur- und Ladezustandsbedingungen zuverlässig vorhergesagt werden kann.

Die Aufgabe wird mit dem gattungsgemäßen Verfahren gemäß Anspruch 1 erfindungsgemäß gelöst durch die Schritte

- Bilden eines Bezugwertes aus dem Bezug zwischen der ermittelten Zustandsgröße und einer entsprechenden Zustandsgröße einer gleichartigen neuwertigen Speicherbatterie bei gleicher Temperaturgröße und gleichem Ladezustand,

- Bestimmen des aktuellen Alterungszustands der Speicherbatterie aus den Bezugswerten und einem Vergleichs-Bezugswert für die gemessene Temperaturgröße und den ermittelten Ladezustand, und

- Bestimmen einer prognostizierten Zustandsgröße als Maß für den Betriebszustand der Speicherbatterie für eine angenommene Temperaturgröße und einen angenommenen Ladezustand bei dem aktuellen Alterungszustand aus bekannten Vergleichs-Bezugswerten, die in Abhängigkeit von der Temperaturgröße, dem Ladezustand und dem Betriebsalter gleichartiger Speicherbatterien aufgenommen wurden.

Der Alterungszustand der Speicherbatterie wird bei der Vorhersage dadurch berücksichtigt, dass ein Bezugswert aus dem Bezug zwischen der ermittelten Zustandsgröße und einer entsprechenden Zustandsgröße einer gleichartigen neuwertigen Speicherbatterie bei einem festen Bezugspunkt, der durch die Temperaturgröße und den Ladezustand definiert ist, gebildet wird. Hierbei wird vorausgesetzt, dass die Abhängigkeit der Zustandsgröße einer neuwertigen Speicherbatterie von der Temperaturgröße und dem Ladezustand bekannt ist.

Es wird vorgeschlagen, Vergleichs-Bezugswerte in Abhängigkeit von der Temperaturgröße, dem Ladezustand und dem Betriebsalter gleichartiger Startbatterien aufzunehmen. Aus dem gebildeten Bezugswert und den aufgenommenen Vergleichs-Bezugswerten kann schließlich als Maß für den Betriebszustand eine prognostizierte Zustandsgröße für beliebig angenommene Temperaturgrößen und Ladezustände bestimmt werden. Hierzu wird der funktionale Zusammenhang zwischen dem Vergleichs-Bezugswert und der Temperatur- und Ladezustandsbedingungen sowie der Alterungseinflüsse ausgewertet.

Die Vergleichs-Bezugswerte können als Werte-Matrix aufgenommen werden. Durch Vergleich des gebildeten Bezugswertes mit den Vergleichs-Bezugswerten der Werte-Matrix in dem für den ermittelten Ladezustand und die gemessene Temperaturgröße geltenden Bereich der Werte-Matrix kann dann auf den mit einem übereinstimmenden Vergleichs-Bezugswert korrelierenden Alterungsgrad eindeutig geschlossen werden. Mit Kenntnis dieses Alterungsgrades können nun aus der Werte-Matrix Vergleichs-Bezugswerte für beliebig angenommene Temperaturgrößen und Ladezustände entnommen und in Kenntnis der Zustandsgröße einer gleichartigen neuwertigen Speicherbatterie bei den beliebig angenommenen Temperatur- und Ladezustandsbedingungen eine prognostizierte Zustandsgröße bestimmt werden. Ebenso können Vorhersagen für zukünftige Betriebszustände unter Annahme eines höheren Betriebsalters in gleicher Weise getroffen werden.

Alternativ können die Vergleichs-Bezugswerte auch funktional aufgenommen sein. Der Alterungszustand bzw. das Betriebsalter der Starterbatterie mit den zugehörigen Vergleichs-Bezugswerten können dann mathematisch aus dem Bezugswert als Funktion der Temperaturgröße, des Ladezustands und des Alterungsgrades, beispielsweise durch Transformation, berechnet werden. In Kenntnis des Betriebsalters ist dann auch die Funktion zur Berechnung der Vergleichs-Bezugswerte für beliebig angenommene Temperaturgrößen und Ladezustände bekannt, so dass eine hierauf basierende Zustandsgröße als Maß für den Betriebszustand leicht bestimmbar ist.

Der Bezugswert wird vorzugsweise aus dem Verhältnis, das heißt dem Quotienten zwischen der ermittelten Zustandsgröße und der entsprechenden Zustandsgröße einer gleichartigen neuwertigen Speicherbatterie berechnet. Alternativ hierzu kann der Bezugswert jedoch auch aus der Differenz zwischen der ermittelten Zustandsgröße und der entsprechenden Zustandsgröße einer gleichwertigen neuwertigen Speicherbatterie bestimmt werden.

Der Betriebszustand einer Speicherbatterie kann vorzugsweise durch Messen und Auswerten des Innenwiderstands der Speicherbatterie als Zustandsgröße ermittelt werden.

Besonders vorteilhaft ist es, wenn das Spannungsminimum der Klemmspannung der Speicherbatterie bei Kurzzeitbelastung als Zustandsgröße gemessen wird. Dieses Spannungsminimum kann als Maß für den Innenwiderstand genutzt werden, da der Spannungseinbruch proportional und das Spannungsminimum in etwa umgekehrt proportional zum Innenwiderstand der Speicherbatterie ist. Das Spannungsminimum kann bei Starterbatterien von Kraftfahrzeugen sehr einfach beim Anlassen des Verbrennungsmotors bestimmt werden.

Die Vergleichs-Bezugswerte können empirisch aus der Betriebserfahrung mit gleichartigen gealterten Speicherbatterien gewonnen oder aus einem mathematischen Batteriemodell der Speicherbatterien berechnet werden.

Insbesondere für funktional aufgenommene Vergleichs-Bezugswerte ist es vorteilhaft, den Bezugswert mittels Transformation des funktionalen Zusammenhangs zwischen den Vergleichs-Bezugswerten und der bei der gemessenen Temperaturgröße und dem ermittelten Ladezustand ermittelten Zustandsgröße auf der Basis der angenommenen Temperaturgröße und des angenommenen Ladezustands zu bestimmen. Aus dem derart bestimmten Bezugswert wird dann die prognostizierte Zustandsgröße berechnet. Hierzu wird ein Bezug zwischen dem Bezugswert und der Zustandsgröße einer gleichwertigen neuwertigen Speicherbatterie, wie beispielsweise der Quotient oder die Differenz, gebildet.

Die Erfindung wird nachfolgend anhand der beigefügten Zeichnungen näher erläutert. Es zeigen:

Fig. 1 - Diagramm einer typischen Abhängigkeit des Innenwiderstands einer Speicherbatterie vom Ladezustand und einem Alterungszustand;

Fig. 2 - Diagramm von Vergleichs-Bezugswerten in Abhängigkeit von dem Ladezustand für verschiedene Alterungszustände;

Fig. 3 - Diagramm von Vergleichs-Bezugswerten in Abhängigkeit von der Batterietemperatur bei vorgegebenem Ladezustand für verschiedene Alterungszustände;

Fig. 4 - Diagramm einer Werte-Matrix mit Vergleichs-Bezugswerten in Ab hängigkeit von dem Ladezustand, einer Temperaturgröße sowie dem Alterungszustand.

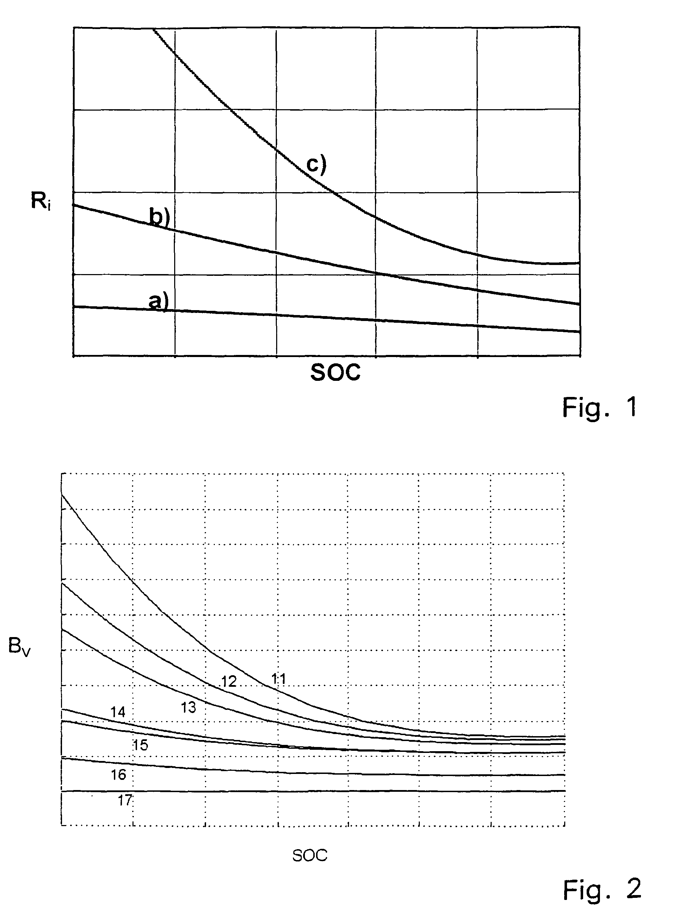

Die Figur 1 lässt ein Diagramm mit unterschiedlichen Verläufen des Innenwiderstands $R_I$ von unterschiedlich stark gealterten Speicherbatterien in Abhängigkeit vom Ladezustand SOC der Speicherbatterien erkennen. Die Temperaturgröße T, die mit der Batterietemperatur $T_{BAT}$ korreliert ist hierbei konstant. Der Innenwiderstand $R_I$ einer neuen Speicherbatterie ist annähernd linear und weist im vollgeladenen Zustand den geringsten Widerstandswert auf. Mit geringer werdendem Ladezustand SOC steigt der Innenwiderstand $R_I$ nur leicht an.

Bei einer leicht gealterten Speicherbatterie ist ein leicht überproportionaler Anstieg des Innenwiderstand $R_I$ mit sinkendem Ladezustand SOC zu beobachten, wie in der Kurve b) skizziert ist.

Aus der Kurve c) ist weiterhin erkennbar, dass bei einer stark gealterten Speicherbatterie im vollgeladenen Zustand ein vergleichsweise höchster Innenwiderstand $R_I$ zu beobachten ist, der mit sinkendem Ladezustand SOC stark überproportional ansteigt.

Die Figur 2 lässt ein Diagramm mit Bezugswerten $B_V$ erkennen, die aus dem Bezug zwischen einer ermittelten Zustandsgröße $A_{IST}$ und einer entsprechenden Zustandsgröße $A_{NEU}$ einer gleichartigen neuwertigen Speicherbatterie gebildet ist. Als Zustandsgröße wird hier beispielhaft wiederum der Innenwiderstand $R_I$ der Speicherbatterie ausgewertet. Die Bezugswerte $B_V$ sind bei einer konstanten Temperaturgröße $T_{IST}$, beispielsweise der Batterietemperatur $T_{BAT}$ selbst, über den Ladezustand SOC aufgetragen.

Dabei ist die zur Kurve 11 Speicherbatterie am stärksten gealtert. Der Alterungsgrad der Speicherbatterien nimmt mit den Kurven 12 bis 16 weiter ab. Die zur Kurve 17 gehörige Speicherbatterie befindet sich im Neuzustand.

In dem dargestellten Ausführungsbeispiel wird der Bezugswert $B_V$ aus dem Quotienten des ermittelten Innenwiderstandes $R_I$ der Speicherbatterie und dem Innenwiderstand $R_I$ der Speicherbatterie im Neuzustand bei gleicher Temperaturgröße $T_{IST}$ und gleichem Ladezustand $SOC_{IST}$ ermittelt. Der zur neuwertigen Speicherbatterie gehörige Kurvenverlauf 17 ist daher eine mit dem Wert 1 parallel zur Abzisse verlaufende Gerade.

Mit zunehmender Alterung der Speicherbatterie steigt der Bezugswert $B_V$ der vollgeladenen Speicherbatterien im Vergleich mit einer neuwertigen Speicherbatterie bis über den 2,5-fachen Wert im weiter an. Dazu addiert sich noch ein Widerstandsanteil, der mit sinkendem Ladezustand SOC und zunehmenden Alterungsgrad immer größer wird.

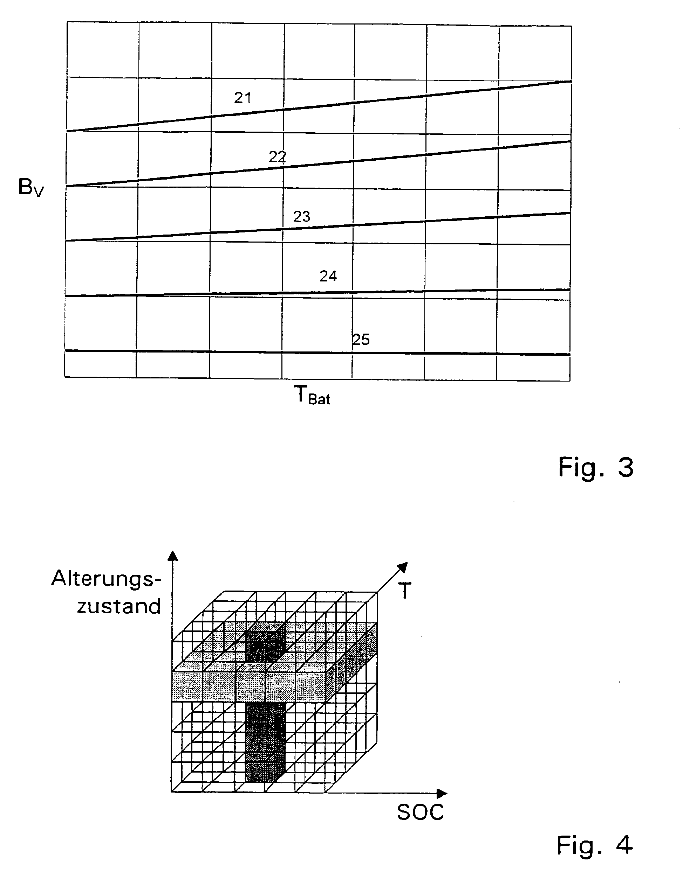

Die Figur 3 zeigt ein Diagramm mit Bezugswerten $B_V$ für verschieden stark gealterte Speicherbatterien als Funktion einer Temperaturgröße $T_{IST}$, die mit der Batterietemperatur $T_{BAT}$ korreliert, vorzugsweise der Batterietemperatur $T_{BAT}$ selbst, erkennen. Der Ladezustand SOC ist hierbei konstant.

Die zur Kurve 21 gehörige Speicherbatterie ist hierbei in dem dargestellten Ausführungsbeispiel am stärksten gealtert. Der Alterungsgrad der Speicherbatterien, auf die sich die Kurven 22 bis 24 beziehen, nimmt ab. Die Kurve 25 bezieht sich auf eine Speicherbatterie im Neuzustand. Auch hier ist der Bezugswert $B_V$ der neuwertigen Speicherbatterie wiederum eine mit dem Wert 1 parallel zur Abzisse verlaufende Gerade.

Mit zunehmender Alterung der Speicherbatterien nimmt der Innenwiderstand $R_I$ immer stärker zu. Zusätzlich steigt der Bezugswert $B_V$ gealterter Speicherbatterien mit zunehmender Batterietemperatur $T_{BAT}$ bzw. mit der Batterietemperatur $T_{BAT}$ korrelierender Temperaturgröße $T_{IST}$ noch weiter an. Deshalb muss zusätzlich zum Ladezustand SOC auch eine mit der Batterietemperatur $T_{BAT}$ korrelierende Temperaturgröße $T_{IST}$ bei der Beurteilung der Leistungsfähigkeit und des Betriebszustandes einer Speicherbatterie mitberücksichtigt werden.

Die dargestellten Abhängigkeiten der Zustandsgröße A und der entsprechenden Bezugswerte $B_V$ von gleichartigen Speicherbatterien können empirisch ermittelt und in einer Werte-Matrix als Vergleichs-Bezugswerte als Funktion der Temperaturgröße T dem Ladezustand SOC und dem Alterungsgrad aufgenommen werden. Vorzugsweise werden die Abhängigkeiten mit Funktionen erfasst und die Koeffizienten der Funktionen in Abhängigkeit von dem Alterungsgrad in einer Koeffizienten-Werte-Matrix abgelegt.

Die Figur 4 lässt ein Diagramm einer Werte-Matrix erkennen, bei der Vergleichs-Bezugswerte $B_T$ in Abhängigkeit von dem Ladezustand SOC, der Temperaturgröße $T_{IST}$, die mit der Batterietemperatur $T_{BAT}$ korreliert, und dem Alterungsgrad abgelegt sind. Die Vergleichs-Bezugswerte $B_T$ sind aus der Zustandsgröße A einer um den jeweiligen Alterungsgrad gealterten Speicherbatterie bezogen auf die Zustandsgröße $A_{NEU}$ einer gleichartigen neuwertigen Speicherbatterie auf der Basis der jeweiligen Temperaturgröße T und Ladezustand SOC bestimmt. Für den Alterungsgrad 0 haben die Vergleichs-Bezugswerte $B_T$ damit den Wert 1.

Zur Ermittlung des Betriebszustands wird zunächst die Temperaturgröße $T_{IST}$ und der Ladezustand $SOC_{IST}$ gemessen. Zudem wird eine weitere Zustandsgröße $A_{IST}$, wie beispielsweise der Innenwiderstand $R_I$ der Speicherbatterie bei den vorherrschenden Umgebungsbedingungen ermittelt. Durch die gemessene Temperaturgröße und T und den Ladezustand SOC ist somit ein durch die dunkelgrau dargestellte Säule skizzierter Bereich von Vergleichs-Bezugswerten $B_T$ in der Werte-Matrix abgegrenzt, aus dem durch Vergleich der Vergleichs-Bezugswerte $B_T$ des Bereichs mit dem aus der ermittelten Zustandsgröße $A_{IST}$ berechneten Bezugswert $B_V$ der Alterungsgrad bestimmt werden kann.

Wenn beispielsweise der Alterungsgrad 3 bestimmt wurde, ist die Ebene der Werte-Matrix für die Vergleichs-Bezugswerte $B_T$ bekannt, in der sämtliche prognostizierte Bezugswerte $B_V$ für alle anderen möglichen Temperatur- und Ladezustandsbedingungen verzeichnet sind. Der für andere Temperaturgrößen T und Ladezustände SOC aus der Werte-Matrix ausgelesene Vergleichs-Bezugswert $B_T$ wird dann wiederum in Bezug mit einer entsprechenden Zustandsgröße $A_{NEU}$ einer gleichartigen neuwertigen Speicherbatterie bei gleicher angenommener Temperaturgröße T und gleichem angenommenen Ladezustand SOC gesetzt und hieraus die prognostizierte Zustandsgröße $A_P$ als Maß für den Betriebszustand unter den angenommenen Temperatur- und Ladezustandsbedingungen bestimmt.

Ebenso kann eine Vorhersage für zukünftige Betriebszustände gemacht werden, indem die Ebenen der Werte-Matrix für entsprechend höhere Alterungsgrade ausgewertet werden.

Wie bereits oben erläutert, kann die Werte-Matrix anstelle der Vergleichs-Bezugswerte $B_T$ lediglich Koeffizienten für Funktionen zur Berechnung der Vergleichs-Bezugswerte $B_T$ beinhalten. Das modellhaft mit der Figur 4 skizzierte Auswerteverfahren ändert sich hierdurch jedoch im Grundsatz nicht.

Die Werte-Matrix mit den Vergleichs-Bezugswerten $B_T$ lässt sich funktional nach der folgenden Gleichung ausdrücken:

$$\frac{A_{IST}}{A_{NEU}} = B_V = B_V\left(SOC, T, (B_V)_B\right),$$

wobei $A_{IST}$ eine Zustandsgröße der Speicherbatterie in dem aktuellen Zustand, beispielsweise der Innenwiderstand der gealterten Batterie, $A_{NEU}$ die Zustandsgröße der gleichartigen neuwertigen Speicherbatterie, $B_V$ das Verhältnis der beiden Zustandsgrößen, $A_{IST}$ und $A_{NEU}$ und $(B_V)_B$ das Verhältnis der Zustandsgrößen $A_{IST}$ zu $A_{NEU}$ unter definierten Bedingungen mit dem Ladezustand $SOC_B$ und der Temperaturgröße $T_B$ ist.

Der Wert $(B_V)_B$, der auf einen festen Bezugspunkt ($SOC_B$ und $T_B$) bezogen ist, ist ein Maß für die Alterung der Speicherbatterie.

Wenn nun die Zustandsgröße $A_{IST}$ bei einem vorherrschenden Ladezustand $SOC_{IST}$ und einer vorherrschenden Temperaturgröße $T_{IST}$ ermittelt wird und die entsprechende Zustandsgröße $A_{NEU}$ einer gleichartigen neuwertigen Speicherbatterie unter den gleichen Bedingungen des Ladezustands $SOC_{IST}$ und der Temperaturgröße $T_{IST}$ bekannt sind, kann der Quotient aus der ermittelten Zustandsgröße $A_{IST}$ und der Zustandsgröße $A_{NEU}$ der gleichartigen neuwertigen Speicherbatterie gebildet und der Bezugswert $B_V$ ermittelt werden. Aus der obigen Funktion kann nun durch Transformation das Maß für den Alterungsgrad bestimmt werden:

$$B_V = F\ (SOC,\ T,\ (B_V)_B)\quad => \quad (B_V)_B = f^{TRANS}\ (SOC_{IST,}\ T_{IST,}\ B_V).$$

Bei dem bekannten Niveau des Alterungsgrades kann aus der zugehörigen Funktion

$$(B_V)_B = (B_V)_B\ (SOC,\ T,\ B_V)$$

ein Vergleichs-Bezugswert $B_T$ bei beliebigen Ladezuständen $SOC_P$ und $T_P$ bestimmt und durch Multiplikation mit dem bekannten Wert für die Zustandsgröße $A_{NEU}$ einer gleichartigen neuwertigen Speicherbatterie bei gleichen angenommenen Temperaturgrößen $T$ und gleichen angenommenen Ladezustand $SOC$ eine entsprechende Zustandsgröße $A_P$, beispielsweise ein prognostizierter Innenwiderstand $R_P$, prognostiziert werden. Mit bekannter Belastung der Speicherbatterie kann mit dem derart bestimmten Innenwiderstand $R_P$ berechnet werden, wie groß der Spannungseinbruch unter den angenommenen Umgebungsbedingungen sein wird. Diese Angabe kann dann z. B. genutzt werden, um zu ermitteln, ob die Speicherbatterie bei den angenommenen Temperatur- und Ladezustandsbedingungen in der Lage ist, einen Verbrennungsmotor zu starten.

**Patentansprüche**

1. Verfahren zur Ermittlung des Betriebszustands einer Speicherbatterie für einen aktuellen Alterungszustand bei angenommenen Temperatur- und Ladezustandsbedingungen mit den Schritten:

    a) Messen einer Temperaturgröße ($T_{IST}$), die mit der Batterietemperatur ($T_{BAT}$) korreliert;
    b) Ermitteln des Ladezustands ($SOC_{IST}$) der Speicherbatterie;
    c) Ermitteln einer weiteren Zustandsgröße ($A_{IST}$) der Speicherbatterie,
    d) Bilden eines Bezugswertes ($B_V$) aus dem Bezug zwischen der ermittelten Zustandsgröße ($A_{IST}$) und einer entsprechenden Zustandsgröße ($A_{NEU}$) einer gleichartigen neuwertigen Speicherbatterie bei gleicher Temperaturgröße ($T_{IST}$) und gleichem Ladezustand ($SOC_{IST}$);
    e) Bestimmen des aktuellen Alterungszustands der Spenherbatterie aus dem Bezugswert ($B_V$) und bekannten Vergleichs-Bezugswerten ($B_T$) für die gemessene Temperaturgröße ($T_{IST}$) und den ermittelten Ladezustand ($SOC_{IST}$),
    f) Bestimmen einen der ermittelten Zustandsgröße entsprechenden prognostizierten Zustandsgröße ($A_P$) als Maß für den Betriebszustand der Speicherbatterie für eine angenommene Temperaturgröße ($T_P$) und einen angenommenen Ladezustand ($SOC_P$) bei dem aktuellen Alterungszustand aus den bekannten Vergleichs-Bezugswerten ($B_T$), wobei diese bekannten Vergleichs-Bezugswerte ($B_T$) in Abhängigkeit von Temperaturgrößen ($T$), Ladezuständen ($SOC$) und dem Alterungszustand gleichartiger Speicherbatterien aufgenommen wurden.

2. Verfahren nach Anspruch 1, **dadurch gekennzeichnet, dass** die Vergleichs-Bezugswerte ($B_T$) als Werte-Matrix aufgenommen sind.

3. Verfahren nach Anspruch 1, **dadurch gekennzeichnet, dass** die Vergleichs-Bezugswerte ($B_T$) funktional aufgenommen sind.

4. Verfahren nach Anspruch 3, **dadurch gekennzeichnet, dass** die Koeffizienten der Funktionen für die Vergleichs-Bezugswerte ($B_T$) in Abhängigkeit von dem Alterungszustand in einer Koeffizienten-Wertematrix abgelegt sind.

**5.** Verfahren nach einem der vorhergehenden Ansprüche, **dadurch gekennzeichnet, dass** der Bezugswert ($B_V$) aus dem Verhältnis zwischen der ermittelten Zustandsgröße ($A_{IST}$) und der entsprechenden Zustandsgröße ($A_{NEU}$) einer gleichartigen, neuwertigen Speicherbatterie berechnet wird.

**6.** Verfahren nach einem der Ansprüche 1 bis 4, **dadurch gekennzeichnet, dass** der Bezugswert ($B_V$) aus der Differenz zwischen der ermittelten Zustandsgröße ($A_{IST}$) und der entsprechenden Zustandsgröße ($A_{NEU}$) einer gleichartigen, neuwertigen Speicherbatterie berechnet wird.

**7.** Verfahren nach einem der vorhergehenden Ansprüche, **dadurch gekennzeichnet, dass** die Zustandsgröße (A) der Innenwiderstand ($R_I$) der Speicherbatterie ist.

**8.** Verfahren nach einem der Ansprüche 1 bis 5, **dadurch gekennzeichnet, dass** die Zustandsgröße (A) das Spannungsminimum der Klemmenspannung der Speicherbatterie bei einer bekannten Belastung, insbesondere beim Anlassen eines Verbrennungsmotors, ist.

**9.** Verfahren nach einem der vorhergehenden Ansprüche, **dadurch gekennzeichnet, dass** die Vergleichs-Bezugswerte ($B_T$) empirisch aus der Betriebserfahrung mit gleichartigen gealterten Speicherbatterien gewonnen werden.

**10.** Verfahren nach einem der Ansprüche 1 bis 7, **dadurch gekennzeichnet, dass** die Vergleichs-Bezugswerte ($B_T$) aus einem mathematischen Batteriemodell der Speicherbatterien berechnet werden.

**11.** Verfahren nach einem der vorhergehenden Ansprüche, **gekennzeichnet durch** Bestimmen eines Bezugswertes ($B_V$) **durch** die angenommene Temperaturgröße ($T_P$) und den angenommenen Ladezustand ($SOC_P$) mittels Transformation des funktionalen Zusammenhangs zwischen den Vergleichs-Bezugswerten ($B_T$) und der bei der gemessenen Temperaturgröße ($T_{IST}$) und dem ermittelten Ladezustand ($SOC_{IST}$) ermittelten Zustandsgröße ($A_{IST}$) und Berechnen der prognostizierten Zustandsgröße ($A_P$) aus dem Bezug zwischen dem Bezugswert ($B_V$) und der Zustandsgröße ($A_{NEU}$) einer gleichwertigen neuwertigen Speicherbatterie.

**Claims**

**1.** A method for determining the operating state of an energy-storage battery for an actual aging state in assumed temperature and state of charge conditions, having the following steps:

a) measurement of a temperature variable ($T_{IST}$) which is correlated with the battery temperature ($T_{BAT}$),
b) determination of the state of charge ($SOC_{IST}$) of the energy-storage battery;
c) determination of a further state variable ($A_{IST}$) of the energy-storage battery;
d) formation of a reference value ($B_V$) from the reference between the determined state variable ($A_{IST}$) and a corresponding state variable ($A_{NEU}$) of an identical, new energy-storage battery with the same temperature variable ($T_{IST}$) and the same state of charge ($SOC_{IST}$);
e) determination of the actual aging state of the energy-storage battery from the reference value ($B_V$) and known comparison reference values ($B_T$) for the measured temperature variable ($T_{IST}$) and the determined state of charge ($SOC_{IST}$);
f) determination of a predicted state variable ($A_P$) corresponding to the determined state variable as a measure of the operating state of the energy-storage battery for an assumed temperature variable ($T_P$) and an assumed state of charge (SOCp) with the actual aging state from the known comparison reference values ($B_T$), wherein these known comparison reference values ($B_T$) have been recorded as a function of temperature variables (T), states of charge (SOC) and the aging state of identical energy-storage batteries.

**2.** The method as claimed in claim 1 **characterized in that** the comparison reference values ($B_T$) are recorded as a value matrix.

**3.** The method as claimed in claim 1 **characterized in that** the comparison reference values ($B_T$) are recorded functionally.

**4.** The method as claimed in claim 3 **characterized in that** the coefficients of the functions for the comparison reference values ($B_T$) are stored in a coefficient value matrix as a function of the aging state.

**5.** The method as claimed in one of the preceding claims **characterized in that** the reference value ($B_V$) is calculated from the ratio between the determined state variable ($A_{IST}$) and the corresponding state variable ($A_{NEU}$) of an identical new energy-storage battery.

**6.** The method as claimed in one of claims 1 to 4 **characterized in that** the reference value ($B_V$) is calculated from the difference between the determined state variable ($A_{IST}$) and the corresponding state variable ($A_{NEU}$) of an identical new energy-storage battery.

**7.** The method as claimed in one of the preceding claims **characterized in that** the state variable (A) is the internal resistance ($R_I$) of the energy-storage battery.

**8.** The method as claimed in one of claims 1 to 5 **characterized in that** the state variable (A) is the voltage minimum of the terminal voltage of the energy-storage battery for a known load, in particular when starting an internal combustion engine.

**9.** The method as claimed in one of the preceding claims **characterized in that** the comparison reference values ($B_T$) are obtained empirically from the operating experience with identical elderly energy-storage batteries.

**10.** The method as claimed in one of claims 1 to 7 **characterized in that** the comparison reference values ($B_T$) are calculated from a mathematical battery model of the energy-storage batteries.

**11.** The method as claimed in one of the preceding claims **characterized by** determination of a reference value ($B_V$) by the assumed temperature variable ($T_P$) and the assumed state of charge ($SOC_P$) by means of transformation of the functional relationship between the comparison reference values ($B_T$) and the state variable ($A_{IST}$) determined for the measured temperature variable ($T_{IST}$) and the determined state of charge ($SOC_{IST}$) and calculation of the predicted state variable ($A_P$) from the reference between the reference value ($B_V$) and the state variable ($A_{NEU}$) of an identical new energy-storage battery.

**Revendications**

**1.** Procédé de détermination de l'état de fonctionnement d'une batterie d'accumulateurs dans un état de vieillissement actuel en présence de conditions de température et d'état de charge supposées, comprenant les étapes suivantes :

a) mesurer une grandeur de température ($T_{réelle}$) en corrélation avec la température de la batterie d'accumulateurs ($T_{BAT}$) ;
b) déterminer l'état de charge ($SOC_{réel}$) de l'accumulateur ;
c) déterminer une autre grandeur d'état ($A_{réelle}$) de la batterie d'accumulateurs ;
d) former une valeur de référence ($B_v$) à partir du rapport entre la grandeur d'état ($A_{réelle}$) déterminée et une grandeur d'état ($A_{nouv}$) correspondante d'une batterie d'accumulateurs neuve du même type avec la même grandeur de température ($T_{réelle}$) et le même état de charge ($SOC_{réel}$) ;
e) déterminer l'état de vieillissement actuel de la batterie d'accumulateurs à partir de la valeur de référence ($B_v$) et de valeurs de référence de comparaison ($B_T$) connues pour la grandeur de température ($T_{réelle}$) mesurée et l'état de charge ($SOC_{réel}$) déterminé,
f) déterminer une grandeur d'état ($A_P$) prévisible correspondant à la grandeur d'état déterminée comme valeur pour l'état de fonctionnement de la batterie d'accumulateurs pour une grandeur de température ($T_P$) supposée et un état de charge ($SOC_P$) supposé à l'état de vieillissement actuel, à partir des valeurs de référence de comparaison ($B_T$) connues, ces valeurs de référence de comparaison ($B_T$) étant enregistrées en fonction de grandeurs de température (T), d'états de charge (SOC) et de l'état de vieillissement de batteries d'accumulateurs du même type.

**2.** Procédé selon la revendication 1,
**caractérisé en ce que**
les valeurs de référence de comparaison ($B_T$) sont enregistrées en forme de matrice de valeurs.

**3.** Procédé selon la revendication 1,
**caractérisé en ce que**
les valeurs de référence de comparaison ($B_T$) sont enregistrées de manière fonctionnelle.

**4.** Procédé selon la revendication 3,
**caractérisé en ce que**
les coefficients des fonctions pour les valeurs de référence de comparaison ($B_T$) sont stockés dans une matrice de valeurs de coefficients en fonction de l'état de vieillissement.

**5.** Procédé selon l'une quelconque des revendications précédentes,
**caractérisé en ce que**
la valeur de référence ($B_v$) est calculée à partir du rapport entre la grandeur d'état ($A_{réelle}$) déterminée et la grandeur d'état ($A_{nouv}$) correspondante d'une batterie d'accumulateurs neuve du même type.

**6.** Procédé selon l'une quelconque des revendications 1 à 4,
**caractérisé en ce que**
la valeur de référence ($B_v$) est calculée à partir de la différence entre la grandeur d'état ($A_{réelle}$) déterminée et la grandeur d'état ($A_{nouv}$) correspondante d'une batterie d'accumulateurs neuve du même type.

**7.** Procédé selon l'une quelconque des revendications précédentes,
**caractérisé en ce que**
la grandeur d'état (A) est la résistance interne ($R_l$) de la batterie d'accumulateurs.

**8.** Procédé selon l'une quelconque des revendications 1 à 5,
**caractérisé en ce que**
la grandeur d'état (A) est le minimum de tension de la tension aux bornes de l'accumulateur en présence d'une sollicitation connue, en particulier lors du démarrage d'un moteur à combustion interne.

**9.** Procédé selon l'une quelconque des revendications précédentes,
**caractérisé en ce que**
les valeurs de référence de comparaison ($B_T$) sont obtenues de manière empirique à partir d'expériences avec des batteries d'accumulateurs vieillies du même type.

**10.** Procédé selon l'une quelconque des revendications 1 à 7,
**caractérisé en ce que**
les valeurs de référence de comparaison ($B_T$) sont calculées à partir d'un modèle mathématique des batteries d'accumulateurs.

**11.** Procédé selon l'une quelconque des revendications précédentes,
**caractérisé par**
la détermination d'une valeur de référence ($B_v$) par la grandeur de température ($T_P$) supposée et l'état de charge ($SOC_P$) supposé au moyen d'une transformation de la relation fonctionnelle entre les valeurs de référence de comparaison ($B_T$) et la grandeur d'état ($A_{réelle}$) déterminée en présence de la grandeur de température ($T_{réelle}$) mesurée et de l'état de charge ($SOC_{réel}$) déterminé, et d'un calcul de la grandeur d'état ($A_P$) prévisible à partir du rapport entre la valeur de référence ($B_v$) et la grandeur d'état ($A_{nouv}$) d'une batterie d'accumulateurs neuve du même type.

Fig. 1

Fig. 2

Fig. 3

Fig. 4